(19) Europäisches Patentamt / European Patent Office / Office européen des brevets

(11) **EP 3 926 664 A1**

(12) **EUROPEAN PATENT APPLICATION**

(43) Date of publication:
**22.12.2021 Bulletin 2021/51**

(51) Int Cl.:
**H01L 21/306** (2006.01)

(21) Application number: **21178013.5**

(22) Date of filing: **07.06.2021**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **17.06.2020 JP 2020104507**

(71) Applicant: **TOKYO OHKA KOGYO CO., LTD.
Kawasaki-shi, Kanagawa 211 0012 (JP)**

(72) Inventors:
• **HIRANO, Isao
KANAGAWA, 211-0012 (JP)**
• **SAITO, Hirokuni
KANAGAWA, 211-0012 (JP)**

(74) Representative: **Plasseraud IP
66, rue de la Chaussée d'Antin
75440 Paris Cedex 09 (FR)**

(54) **METHOD FOR ETCHING SEMICONDUCTOR SUBSTRATE AND ETCHANT**

(57)     To provide a method for etching a semiconductor substrate, the method allowing the semiconductor substrate to be etched at a low temperature of about room temperature; and an etching therefor.

A method for etching a semiconductor substrate using an etchant, the etchant including hydrogen fluoride and platinum particles, and the method including an etchant contacting step of bringing the semiconductor substrate and the etchant into contact with each other while allowing the etchant to flow or while moving the semiconductor substrate.

EP 3 926 664 A1

**Description**

This application is based on and claims the benefit of priority from Japanese Patent Application No. 2020-104507, filed on 17 June 2020, the content of which is incorporated herein by reference.

BACKGROUND OF THE INVENTION

Field of the Invention

The present invention relates to a method for etching a semiconductor substrate and an etchant.

Related Art

When manufacturing semiconductor substrates (wafers) such as SiC substrates, it is desired to manufacture smooth semiconductor substrates by removing machining damage layers such as residual crack layers or machining strain layers generated during machining steps such as mechanical polishing or grinding to thereby prevent machining flaws from remaining or occurring on semiconductor substrates to be manufactured. Wet etching using etchants has been contemplated as a method for removing the machining damage layers on the SiC substrates. However, the wet etching of the SiC substrates has generally been performed using molten salts of potassium hydroxide at a high temperature of 360°C or more. There is a need for an etching method at a low temperature in order to avoid etching operation in a high temperature range. A technique for wet-etching a single crystal SiC wafer using a wet etchant containing $KMnO_4$ and NaOH has been disclosed as a technique which allows a SiC substrate to be etched at a temperature lower than 360°C (see Patent Document 1).

Patent Document 1: Japanese Unexamined Patent Application, Publication No. 2017-41526

SUMMARY OF THE INVENTION

However, the technique according to the Patent Document 1 needs heating of the etchant to 50°C to 140°C, and, therefore, there is a desire for etching at a low temperature of about room temperature.

The present invention has been made in view of the above-mentioned problem and an object of the present invention is to provide a method for etching a semiconductor substrate, the method allowing the semiconductor substrate to be etched at a low temperature of about room temperature; and an etching therefor.

The present inventors have conducted extensive studies to achieve the above-mentioned object and have found that the problem can be solved by using an etchant including hydrogen fluoride and platinum particles and bringing a semiconductor substrate and the etchant into contact with each other while allowing the etchant to flow or while moving the semiconductor substrate. Thus, the present invention has been completed. Specifically, the present invention provides the following.

A first aspect of the present invention relates to a method for etching a semiconductor substrate using an etchant, the etchant including hydrogen fluoride and platinum particles, and

the method including an etchant contacting step of bringing the semiconductor substrate and the etchant into contact with each other while allowing the etchant to flow or while moving the semiconductor substrate.

A second aspect of the present invention relates to an etchant including hydrogen fluoride and platinum particles.

The present invention can provide a method for etching a semiconductor substrate, the method allowing the semiconductor substrate to be etched at a low temperature of about room temperature; and an etching therefor.

DETAILED DESCRIPTION OF THE INVENTION

A method of etching a semiconductor substrate is a method for etching a semiconductor substrate using an etchant, the etchant including hydrogen fluoride and platinum particles, and the method including an etchant contacting step of bringing the semiconductor substrate and the etchant into contact with each other while allowing the etchant to flow or while moving the semiconductor substrate.

Hereinafter, the etchant which can be used for the etching method and the etching method will be successively described in detail.

<Etchant>

The etchant includes hydrogen fluoride and platinum particles.

A size of the platinum particles is not particularly limited, but platinum nanoparticles are preferably used as the platinum particles. An average particle size of the platinum nanoparticles is, for example, 30 nm or less, preferably 10 nm or less, and more preferably 6 nm or less. The average particle size of the platinum nanoparticles is, for example, 0.1 nm or more, preferably 0.5 nm or more, and more preferably 1 nm or more. Note that, the average particle size can be calculated from a particle size distribution as measured by, for example, a dynamic light scattering (DLS) method and is, for example, d50. When the platinum particles are fine as mentioned above, the platinum particles tend to be uniformly and well dispersed in the etchant and tend to achieve a desired effect by using the platinum particles due to their high specific surface area.

A concentration of the platinum particles in the etchant is not particularly limited, but is, for example, 0.005% by mass or more, preferably 0.01% by mass or more, more preferably 0.015% by mass or more, and further preferably 0.065% by mass or more relative to a total mass of the etchant. An upper limit of the concentration of the platinum particles in the etchant is not particularly limited, but is, for example, 0.25% by mass or less relative to a total mass of the etchant.

A concentration of the hydrogen fluoride in the etchant is not particularly limited, but is, for example, preferably 1% by mass or more, more preferably 5% by mass or more, and further preferably 10% by mass or more relative to a total mass of the etchant. An upper limit of the concentration of the hydrogen fluoride in the etchant is not particularly limited, but is, for example, preferably 30% by mass or less, more preferably 20% by mass or less, and further preferably 15% by mass or less relative to a total mass of the etchant.

The etchant may include water or ammonium fluoride. When the etchant includes water, an amount of the water included in the etchant is not particularly limited, but is, for example, preferably 10% by mass or more, more preferably 25% by mass or more, and further preferably 40% by mass or more relative to a total mass of the etchant. An upper limit of the amount of the water in the etchant is not particularly limited, but is, for example, preferably 90% by mass or less, more preferably 80% by mass or less, and further preferably 70% by mass or less relative to a total mass of the etchant. Note that, when the etchant includes the water, the hydrogen fluoride is dissolved in water and turns into hydrofluoric acid.

When the etchant includes the ammonium fluoride, a concentration of the ammonium fluoride in the etchant is not particularly limited, but is, for example, preferably 1% by mass or more, more preferably 3% by mass or more, and further preferably 5% by mass or more relative to a total mass of the etchant. An upper limit of the concentration of the ammonium fluoride in the etchant is not particularly limited, but is, for example, preferably 20% by mass or less, more preferably 15% by mass or less, and further preferably 10% by mass or less relative to a total mass of the etchant. Note that, when the etchant includes the ammonium fluoride, the following dissociation or binding takes place in the etchant:

$$HF \rightarrow H^+ + F^- ... \qquad (1)$$

$$HF + F^- \rightarrow HF_2^- ... \qquad (2)$$

$$NH_4F \rightarrow NH_4^+ + F^- ... \qquad (3)$$

Therefore, an amount of use of the ammonium fluoride can be adjusted to adjust a concentration of HF or $HF_2^-$ involved in etching in the etchant and thus to control, for example, an etching rate.

The etchant may include other components which are components other than the above-mentioned components. Examples of the other components which may be included in the etchant include a water-soluble organic solvent, a surfactant, an antioxidant, and a metal corrosion inhibitor.

Examples of the water-soluble organic solvent include alcohols (e.g., methanol, ethanol, ethylene glycol, propylene glycol, glycerin, 1,3-propanediol, 1,3-butanediol, 1,4-butanediol, diethylene glycol, dipropylene glycol, furfuryl alcohol, and 2-methyl-2,4-pentanediol, etc.), dimethyl sulfoxide, ethers (e.g., ethylene glycol dimethyl ether, diethylene glycol dimethyl ether, triethylene glycol dimethyl ether, tetraethylene glycol dimethyl ether, propylene glycol dimethyl ether), etc.

When the etchant includes the water-soluble organic solvent, a content of the water-soluble organic solvent is preferably 50% by mass or less, more preferably 45% by mass or less, and particularly preferably 40% by mass or less relative to a total amount of the water and the water-soluble organic solvent.

As the surfactant, a nonionic surfactant, an anionic surfactant, a cationic surfactant, and an amphoteric surfactant can be used.

Examples of the nonionic surfactant include a polyalkylene oxide alkyl phenyl ether-based surfactant, a polyalkylene oxide alkyl ether-based surfactant, a block polymer-based surfactant composed of polyethylene oxide and polypropylene oxide, a polyoxyalkylene distyrenated phenyl ether-based surfactant, a polyalkylene tribenzyl phenyl ether-based surfactant, an acetylene polyalkylene oxide-based surfactant, and the like.

Examples of the anionic surfactant include alkyl sulfonic acid, alkylbenzene sulfonic acid, alkyl naphthalene sulfonic acid, alkyl diphenyl ether sulfonic acid, fatty acid amide sulfonic acid, polyoxyethylene alkyl ether carboxylic acid, polyoxyethylene alkyl ether acetic acid, polyoxyethylene alkyl ether propionic acid, alkyl phosphonic acid, fatty acid, and salts thereof. Examples of the "salts" include an ammonium salt, a sodium salt, a potassium salt, a tetramethylammonium salt, and the like.

Examples of the cationic surfactant include a quaternary ammonium salt-based surfactant or an alkylpyridium-based surfactant.

Examples of the amphoteric surfactant include a betaine type surfactant, an amino acid type surfactant, an imidazoline type surfactant, an amine oxide type surfactant, and the like. In general, these surfactants are commercially available. Furthermore, these surfactants can be used alone or in a mixture of two or more thereof.

Examples of the antioxidant include a transition metal oxide, a peroxide, ceric ammonium nitrate, a nitrate, a nitrite, iodic acid, periodic acid, an iodate, a periodate, a perchlorate, persulfuric acid, persulfates, peracetic acid, a peracetate, a permanganate compound, a bichromate compound, and the like.

Examples of the metal corrosion inhibitor include polyethyleneimine, thiol, benzotriazole, and the like.

A method for producing the etchant is not particularly limited and, for example, the etchant may be produced by mixing components thereof. For the platinum particles, a dispersion liquid in which the platinum particles are dispersed in a solvent, for example, a water-soluble organic solvent such as water, ethanol, or isopropanol may be prepared in advance and mixed with the other components.

Such an etchant can be used to etch the semiconductor substrate at a low temperature of about room temperature. The etchant may also achieve a semiconductor substrate with a relatively flat etched surface.

<Etching method>

A method for etching a semiconductor substrate is a method for etching a semiconductor substrate using the above-mentioned etchant. The method for etching a semiconductor substrate includes an etchant contacting step of bringing the semiconductor substrate and the etchant into contact with each other while allowing the etchant to flow or while moving the semiconductor substrate.

Examples of the semiconductor substrate to be treated with the etchant include a SiC substrate, a Si substrate, and a GaN substrate. The semiconductor substrate may be either single-crystalline, polycrystalline, or amorphous. The SiC substrate is a substrate which is particularly difficult to etch due to its chemical stability, but the above-mentioned method for etching a semiconductor substrate can be used to etch well even the SiC substrate.

In the etchant contacting step of the method for etching a semiconductor substrate, the semiconductor substrate and the etchant are brought into contact with each other while allowing the etchant to flow or while moving the semiconductor substrate. In other words, in the etchant contacting step, the semiconductor substrate and the etchant may be brought into contact with each other while allowing the etchant to flow or while moving the semiconductor substrate. Alternatively, the etchant and the semiconductor substrate may be brought into contact with each other while allowing the etchant to flow and moving the semiconductor substrate. Thus, it is believed that etching of the semiconductor substrate with the etchant including hydrogen fluoride and platinum particles efficiently proceeds since the etchant and the semiconductor substrate are kept in collision against each other when the semiconductor substrate and the etchant are brought into contact with each other while allowing the etchant to flow or while moving the semiconductor substrate.

The method for bringing the semiconductor substrate and the etchant into contact with each other while allowing the etchant to flow may be a method in which the etchant is added into a container and at least one of the etchant and the container is moved while the semiconductor substrate is immersed in the etchant contained in the container. For example, the etchant or the container can be moved by stirring the etchant or rotating the container. The method for bringing the semiconductor substrate and the etchant into contact with each other while allowing the etchant to flow may also be a method in which the etchant is allowed to continuously flow onto the semiconductor substrate placed on a stand. The semiconductor substrate and the etchant may also be brought into contact with each other while allowing the etchant to flow by drawing out the etchant from the container simultaneously with supplying the etchant into the container while the semiconductor substrate is immersed in the etchant contained in the container. In this case, a rate of supplying the etchant into a solution may be the same as or different from a rate of drawing out the etchant from the container.

The method for bringing the semiconductor substrate and the etchant into contact with each other while moving the semiconductor substrate may be a method in which the semiconductor substrate is moved while the semiconductor substrate is immersed in the etchant contained in the container. The semiconductor substrate may be rotationally moved or simply moved. One exemplary method for rotating the semiconductor substrate is a method in which a rotatable plate-like table (rotating table) is rotated while the semiconductor substrate is placed on the table. In this method, the table is rotated about a rotation axis extending in a thickness direction of the table.

A time period (treatment time) for which the semiconductor substrate and the etchant are brought into contact with each other while allowing the etchant to flow or while moving the semiconductor substrate is not particularly limited, but is, for example, 1 minute or more but 600 minutes or less.

Such a method for etching a semiconductor substrate allows the semiconductor substrate such as the SiC substrate to be etched at a low temperature of about room temperature such as 25°C or less. Therefore, the above-mentioned method for etching a semiconductor substrate can be performed at 25°C or less, in other words, without heating.

For example, a machining damage layer such as a residual crack layer or a machining strain layer generated during a machining step such as mechanical polishing or grinding in the manufacture of the semiconductor substrate can be removed through etching using the above-mentioned method for etching a semiconductor substrate.

In the above-mentioned method for etching a semiconductor substrate, an etching rate is, for example, 10 nm/min or more, preferably 20 nm/min or more, more preferably 30 nm/min or more, and further preferably 40 nm/min or more at a low temperature of about room temperature. An upper limit of the etching rate is not particularly limited, but is, for example, 200 nm/min or less. Note that, as used herein, the "etching rate" is a value of an etching depth generated by the etching treatment using the etchant divided by an etching treatment time and can be determined by the following expression:

$$\text{[Difference in mass of semiconductor substrate before and after etching treatment]} / \{\text{[Density of semiconductor substrate]} \times \text{[Area of semiconductor substrate]} \times \text{Etching treatment time}\}.$$

Furthermore, the etching often roughens a surface of the semiconductor substrate, but the above-mentioned method for etching a semiconductor substrate can result in a semiconductor substrate with a relatively flat etched surface. Arithmetic mean roughness (surface roughness Ra) of a surface of the semiconductor substrate after the semiconductor substrate is etched by the above-mentioned method for etching a semiconductor substrate is not particularly limited, but is, for example, 15 nm or less, preferably 10 nm or less, and further preferably 5 nm or less. The surface roughness Ra is preferably as close to zero as possible, but may be, for example, 0.01 nm or more.

EXAMPLES

The present invention will be described in more detail by way of Examples, but the present invention is not limited to these Examples.

[Example 1 and Comparative Examples 1 to 6]

(Production of etchant)

Components of types and amounts described in Table 1 were mixed together to obtain etchants of Example and Comparative Examples. Note that, in the Table 1, the component names are described in the upper rows and masses thereof are described in parentheses in the lower rows. Furthermore, a Pt particle dispersion liquid used in Example was a solution of Pt particles having a particle size of 1 to 6 nm in water-ethanol (product name: Pt nanoparticle dispersion, manufactured by Renaissance Energy Research, concentration of Pt particles: 0.195% by mass, water:ethanol = 1:1 (by mass)).

(Etching treatment)

In Example 1, a cylindrical container which had been charged with the resultant etchant was placed on a rotating table. Then, a SiC single crystal substrate (specimen of which Si surface was a rectangle of 1 cm x 1 cm and which had a thickness of 0.1 cm) was added to the container and simultaneously, the rotating table was rotated while the SiC single crystal substrate was immersed in the etchant. By rotating the rotating table, the etchant was brought into contact with the semiconductor substrate while the etchant was flowing. Thereafter, the SiC single crystal substrate was removed from the container, washed with water, and then dried with nitrogen. In each of Comparative Examples 2 to 6, a cylindrical container which had been charged with the resultant etchant was placed on a heating table and the etchant was heated. Then, a SiC single crystal substrate (specimen of which Si surface was a rectangle of 1 cm x 1 cm and which had a thickness of 0.1 cm) was added to the container and the SiC single crystal substrate was immersed in the etchant while keeping the heating temperature. Thereafter, the SiC single crystal substrate was removed from the container, washed with water, and then dried with nitrogen. Furthermore, procedures of Comparative Example 1 were the same as in the Comparative Examples 2 to 6, except that the etchant was not heated. Note that, the cylindrical container and the SiC single crystal substrate used in each of the Comparative Examples 1 to 6 were the same as in the Example. A temperature of the etchant (treatment temperature) and an immersion time (treatment time) are described in Table 1. In the Table 1, the treatment temperature of RT denotes 25°C.

[Evaluation of etching property]

A difference in mass of the SiC single crystal substrate before and after the etching treatment (Decreased mass) was determined. Furthermore, an etching rate (E. R. equivalent) (nm/min) was determined by the following expression. The results are presented in Table 1.

```
E.R. equivalent (nm/min) = [Difference in mass of SiC single crystal substrate before and after etching treatment] /

{[Density of SiC single crystal substrate] x [Area of Si

surface of SiC single crystal substrate] x Treatment time}
```

[Evaluation of flatness]

The SiC single crystal substrate after the etching treatment was measured for surface roughness Ra using an atomic force microscope (AFM). This measurement was performed using (Wide range AFM AS-7B-$\mu$X, manufactured by TAKANO Co., Ltd.). The results are presented in Table 1. Note that, in the [Evaluation of etching property], the Comparative Examples 1 and 3 to 6 which had extremely small or zero decreased masses were not measured for the surface roughness Ra after the etching treatment since they had not been substantially etched. Furthermore, the SiC single crystal substrate before the etching treatment was measured for surface roughness Ra in the same manner and determined to be 0.6 nm.

[Table 1]

| | Example 1 | Comparative Example 1 | Comparative Example 2 | Comparative Example 3 | Comparative Example 4 | Comparative Example 5 | Comparative Example 6 |
|---|---|---|---|---|---|---|---|
| Etchant | HF (1.25g) | HF (1.25g) | $KMnO_4$ (0.61g) | $KMnO_4$ (1.0g) | Sulfuric acid (14.7g) | KOH (2.0g) | KOH (3.0g) |
| | $NH_4$ F (0.74g) | $NH_4F$ (0.74g) | NaOH (7.92g) | Sodium metasilicate (1.31g) | $H_2O_2$ (1.55g) | $KMnO_4$ (0.61g) | Sodium metasilicate (3g) |
| | Pt particle dispersion liquid (5.0g) | - | - | Trisodium phosphate (0.784g) | - | Sodium metasilicate (6g) | - |
| | Water (3.01g) | Water (8.01g) | Water (16.1g) | Water (16.91g) | Water (3.75g) | Water (17.0g) | Water (14.0g) |
| Treatment temperature (°C) | RT | RT | 140 | 120 | 140 | 140 | 120 |
| Treatment time (min) | 60 | 60 | 60 | 60 | 30 | 60 | 60 |
| Decreased mass (mg) | 7.80 | 0 | 1.23 | 0.06 | 0.04 | 0.21 | 0 |
| E. R. equivalent (nm/min) | 40.6 | 0 | 6.47 | 0.31 | 0.21 | 0.11 | 0 |
| Surface roughness Ra (nm) | 2.13 | - | 25.32 | - | - | - | - |

It can be seen from the Example 1 that the etchant including hydrogen fluoride and platinum particles allowed etching at room temperature. Furthermore, it can be seen that the semiconductor substrate etched in the Example 1 had a low surface roughness Ra and was flat.

Meanwhile, it can be seen from the Comparative Examples 1 to 6 in which etchants other than the etchant including hydrogen fluoride and platinum particles were used, etching could not be performed at a low temperature of about room temperature and even when the etching is performed at a high temperature of 120 to 140°C, the decreased masses were smaller than that of the Example 1, in other words, the etching was unsatisfactory. Furthermore, the decreased mass in the Comparative Example 2 was larger than those of other Comparative Examples, but significantly smaller than that of the Example 1. Additionally, the surface roughness Ra was also high.

**Claims**

1. A method for etching a semiconductor substrate using an etchant,
   the etchant comprising hydrogen fluoride and platinum particles, and
   the method comprising an etchant contacting step of bringing the semiconductor substrate and the etchant into contact with each other while allowing the etchant to flow or while moving the semiconductor substrate.

2. The method for etching a semiconductor substrate according to claim 1, wherein, in the etchant contacting step, while the semiconductor substrate is immersed in the etchant contained in a container, at least one of the etchant, the container, and the semiconductor substrate is moved.

3. The method for etching a semiconductor substrate according to claim 2, wherein, in the etchant contacting step, at least one of stirring of the etchant, rotation of the container, and rotation of the semiconductor substrate is performed.

4. The method for etching a semiconductor substrate according to any one of claims 1 to 3, wherein the method is performed at 25°C or less.

5. The method for etching a semiconductor substrate according to any one of claims 1 to 4, wherein the platinum particles are platinum nanoparticles.

6. The method for etching a semiconductor substrate according to any one of claims 1 to 5, wherein the etchant comprises water.

7. The method for etching a semiconductor substrate according to any one of claims 1 to 6, wherein the etchant comprises ammonium fluoride.

8. The method for etching a semiconductor substrate according to any one of claims 1 to 7, wherein the semiconductor substrate is a SiC substrate.

9. An etchant comprising: hydrogen fluoride, and platinum particles.

10. The etchant according to claim 9, wherein the platinum particles are platinum nanoparticles.

11. The etchant according to claim 9 or 10, comprising water.

12. The etchant according to any one of claims 9 to 11, comprising ammonium fluoride.

Europäisches
Patentamt

European
Patent Office

Office européen
des brevets

# EUROPEAN SEARCH REPORT

Application Number

EP 21 17 8013

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/098582 A1 (SANO MITSUO [JP] ET AL) 26 March 2020 (2020-03-26) | 9-12 | INV. H01L21/306 |
| A | * paragraphs [0040] - [0042], [0062] - [0068] * | 1-8 | |
| | ----- | | |
| A | US 2008/090074 A1 (MATSUMURA MICHIO [JP] ET AL) 17 April 2008 (2008-04-17) * claims * | 1-12 | |
| | ----- | | |

TECHNICAL FIELDS
SEARCHED     (IPC)

H01L

The present search report has been drawn up for all claims

| Place of search | Date of completion of the search | Examiner |
|---|---|---|
| The Hague | 13 October 2021 | Gori, Patrice |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**EP 3 926 664 A1**

## ANNEX TO THE EUROPEAN SEARCH REPORT
## ON EUROPEAN PATENT APPLICATION NO.

EP 21 17 8013

This annex lists the patent family members relating to the patent documents cited in  the above-mentioned European search report.
The members are as contained in the European Patent Office EDP file on
The European Patent Office is in no way liable for these particulars which are merely given for the purpose of information.

13-10-2021

| Patent document cited in search report | | Publication date | Patent family member(s) | | Publication date |
|---|---|---|---|---|---|
| US 2020098582 | A1 | 26-03-2020 | JP | 2020053520 A | 02-04-2020 |
| | | | US | 2020098582 A1 | 26-03-2020 |
| | | | US | 2021217626 A1 | 15-07-2021 |
| US 2008090074 | A1 | 17-04-2008 | JP | 4807754 B2 | 02-11-2011 |
| | | | JP | 5270639 B2 | 21-08-2013 |
| | | | JP | 2011101009 A | 19-05-2011 |
| | | | JP | WO2006051727 A1 | 29-05-2008 |
| | | | TW | 200620451 A | 16-06-2006 |
| | | | US | 2008090074 A1 | 17-04-2008 |
| | | | WO | 2006051727 A1 | 18-05-2006 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020104507 A

- JP 2017041526 A